Europäisches Patentamt

European Patent Office

Office européen des brevets

(19)

(11) Publication number: **0 331 251**
**A2**

## (12) EUROPEAN PATENT APPLICATION

(21) Application number: **89200463.1**

(51) Int. Cl.⁴: **H02H 9/04 , H03K 17/08**

(22) Date of filing: **24.02.89**

(30) Priority: **02.03.88 IT 2077288 U**

(43) Date of publication of application:
**06.09.89 Bulletin 89/36**

(84) Designated Contracting States:
**DE ES FR GB IT**

(71) Applicant: **I.R.E. Industrie Riunite Eurodomestici S.p.A.**

**I-21024 Cassinetta di Biandronno (Varese)(IT)**

(84) **ES IT**

Applicant: **N.V. Philips' Gloeilampenfabrieken Groenewoudseweg 1 NL-5621 BA Eindhoven(NL)**

(84) **DE FR GB**

(72) Inventor: **Vasconi, Enrico**
c/o INT. OCTROOIBUREAU B.V. Prof. **Holstlaan 6**
**NL-5656 AA Eindhoven(NL)**
Inventor: **Mazzucchelli, Carlo**
c/o INT. OCTROOIBUREAU B.V. Prof. **Holstlaan 6**
**NL-5656 AA Eindhoven(NL)**
Inventor: **Torriani, Diego**
c/o INT. OCTROOIBUREAU B.V. Prof. **Holstlaan 6**
**NL-5656 AA Eindhoven(NL)**

(74) Representative: **Zwaan, Andries Willem et al INTERNATIONAAL OCTROOIBUREAU B.V. Prof. Holstlaan 6**
**NL-5656 AA Eindhoven(NL)**

(54) Overvoltage protection device for control circuits using power transistors.

(57) A protection device for circuits comprising at least one power transistor, for example PMOS or NMOS transistor, for controlling by modulation the speed of a direct current motor fed from the electricity mains through a rectifier, characterised in that at least one varistor (10) is provided in parallel with the input of the rectifier (3) and at least one varistor (11) is provided in parallel with the power transistor.

Xerox Copy Centre

# OVERVOLTAGE PROTECTION DEVICE FOR CONTROL CIRCUITS USING POWER TRANSISTORS

This utility model relates to a device for the overvoltage protection of at least one power transistor, for example PMOS or NMOS transistors, used for controlling the speed of a direct current motor with which it is connected in series.

With particular but not exclusive reference to the domestic washing machine field, it is known to use a direct current motor for driving the laundry drum at different speeds depending on the various stages of the wash program. For this purpose chopper control circuits are used employing static switches of the triac type. However the use of triacs involves certain drawbacks, among which are the relatively low switching speed of triacs and the need to use large currents for their control. The use of power transistors, for example PMOS or NMOS transistors, instead of triacs, which would obviate or reduce these drawbacks, has up to the present time been opposed by the fact that power transistors cannot withstand overvoltages beyond a certain extent.

An object of the present utility model is therefore to allow the use of power transistors, for example PMOS or Nmos transistors in chopper speed control circuits for direct current motors.

This and further objects which will be more apparent from the detailed description given hereinafter are attained according to the present utility model by a protection device for circuits comprising at least one power transistors, for example PMOS or NMOS transistors, for controlling the speed of a direct current motor fed from the electricity mains through a rectifier, said device being characterised essentially in that at least one varistor is provided in parallel with the rectifier input and at least one varistor is provided in parallel with the power transistor.

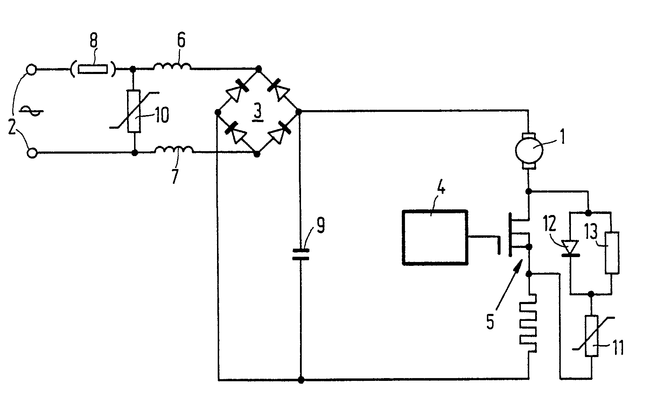

The utility model will be more apparent from the detailed description given by way of example hereinafter with reference to the single figure of the accompanying drawing, which shows the device according to the utility model.

In the figure, the refence numeral 1 indicates a direct current motor intended for example for driving the drum of a domestic washing machine at different speeds. The motor is fed from the electricity mains 2 through a rectifier bridge 3. The electrical supply to the motor 1 is controlled by a chopper control circuit 4 which modulates the direct current signal in accordance with the wash program so as to cause the motor to rotate at the speed scheduled for the specific stage of the program. The control is effected by a power transistor 5 (for example a PMOS transistor) connected in series with the motor 1.

In conventional manner, between the mains 2 and rectifier bridge 3 there are provided a reactive impedance/6,7 in each conductor and a fuse 8, a capacitor 9 being connected in parallel with the output of the rectifier bridge.

According to the utility model, a varistor 10 is provided in parallel with the input of the rectifier bridge 3. In a branch parallel to the power transistor 5 there are provided a further varistor 11, a diode 12 in series with this latter, and a resistor 13 in parallel with the diode. The diode 12 and resistor 13 dissipate the energy which accumulates in the varistor 11.

When mains voltage peaks occur, the varistors 10, 11, by reducing their resistance, limit the voltage across the power transistor 5 to thus protect it against failure.

## Claims

1. A protection device for circuits comprising at least one power transistor, for example PMOS or NMOS transistor,for controlling by modulation the speed of a direct current motor fed from the electricity mains through a rectifier, characterised in that at least one varistor (10) is provided in parallel with the input of the rectifier (3) and at least one varistor (11) is provided in parallel with the power transistor.

2. A device as claimed in claim 1, characterised in that the varistor (11) provided in parallel with the power transistor (5) is in series with a diode (12), which is in parallel with a resistor (13).